# EUROPEAN PATENT APPLICATION

(11) **EP 4 421 871 A1**
(43) Date of publication of application: **28.08.2024**
(21) Application number: 21961124.1
(22) Date of filing: 27.10.2021
(51) Int. Cl.: H01L 27/146

(54) **PIXEL-LEVEL ENCAPSULATION STRUCTURE OF UNCOOLED INFRARED DETECTOR, AND MANUFACTURING METHOD THEREFOR**

(30) Priority: 19.10.2021 CN 202111217019
(71) Applicant: Yantai Raytron Technology Co., Ltd., Yantai, Shandong 264006 (CN)
(72) Inventor: LIU, Jiwei, Yantai, Shandong 264006 (CN); HU, Hanlin, Yantai, Shandong 264006 (CN); CHEN, Wenli, Yantai, Shandong 264006 (CN); SHI, Jie, Yantai, Shandong 264006 (CN); ZHAO, Wenguang, Yantai, Shandong 264006 (CN); WANG, Jinhua, Yantai, Shandong 264006 (CN)
(74) Representative: Studio Torta S.p.A.
(86) International application number: PCT/CN2021/126704
(87) International publication number: WO 2023/065382

(57) **Abstract**

A pixel-level encapsulation structure of an uncooled infrared detector, and a manufacturing method therefor. The pixel-level encapsulation structure comprises an integrated circuit substrate and a pixel device, which is arranged on the upper surface of the integrated circuit substrate, wherein the pixel device comprises a pixel unit and an air suction unit, which is arranged on a side of the pixel unit; the air suction unit comprises a getter layer, which is arranged on the upper surface of the integrated circuit substrate, a support layer, and a sealing layer, which is arranged on an upper surface of the support layer, and a cavity in the air suction unit is in communication with a cavity in the pixel unit; or the pixel device comprises a getter layer and a reflective layer, which are arranged on the upper surface of the integrated circuit substrate, and an infrared sensor unit, which is arranged above the reflective layer and corresponds to the reflective layer. The pixel device comprises the pixel unit and the air suction unit, which is arranged on the side of the pixel unit, and the getter layer is not arranged in the pixel unit; or the getter layer in the pixel device does not correspond to the infrared sensor unit. In this way, the impact of the getter layer on the infrared sensor unit is avoided, thereby improving the performance of an uncooled infrared detector.

## Description

The present application claims the priority to Chinese Patent Application No. 202111217019.8, titled "PIXEL-LEVEL ENCAPSULATION STRUCTURE OF UNCOOLED INFRARED DETECTOR, AND MANUFACTURING METHOD THEREFOR", filed with the China National Intellectual Property Administration on October. 19, 2021, which is incorporated herein by reference in its entirety.

### FIELD

The present application relates to the technical field of infrared imaging, and in particular to a pixel-level package structure of an uncooled infrared detector and a manufacturing method thereof.

### BACKGROUND

As a fourth-generation packaging technology of an uncooled infrared focal plane detector, pixel-level packaging refers to a packaging of a single pixel or a series of pixels, where MEMS (Micro-Electro-Mechanical System) manufacturing process is performed on a bottom COMS (Complementary Metal Oxide Semiconductor) integrated circuit substrate wafer. Compared to wafer-level packaging, the pixel-level packaging can save the designing and processing for one pieces of wafer while not requiring a bonding process, which significantly simplifies the manufacturing process and saves the processing time.

A getter is a necessary material to ensure normal performance of a pixel-level package structure of an uncooled infrared detector. In the pixel-level package structure, a getter layer is generally arranged at an upper surface of the integrated circuit substrate, and is in correspondence to an infrared sensor unit. That is, the getter layer is located below a micro bolometer. A cracked rough structure presented on a surface of the getter layer can reduce the reflectance of the getter layer. The better a gettering performance is, the more significant the cracked rough structure on the surface is. Therefore, the getter layer can apply an absorption effect on the infrared radiation, reduces the reflection of the infrared radiation, and further affects the absorption of the infrared radiation by the infrared sensor unit, thereby further affecting the performance of the pixel-level package structure of an uncooled infrared detector. Due to characteristics of a process for pixel-level packaging, the getter layer arranged inside a pixel chamber has to resist the influence of oxidation during organic resist releasing process. The organic resist releasing process lowers the reflectance of the getter, which affects the detection precision of the infrared detector.

Therefore, those skilled in the art are focused on how to solve the above technical problem.

### SUMMARY

An object of the present application is to provide a pixel-level package structure of an uncooled infrared detector and a manufacturing method thereof to improve the performance of the pixel-level package structure of the uncooled infrared detector.

In order to solve the above technical problem, a pixel-level package structure of an uncooled infrared detector is provided in the present application, including:
an integrated circuit substrate, and a pixel device arranged on an upper surface of the integrated circuit substrate,
the pixel device includes a pixel unit and a getter unit arranged at a side of the pixel unit, the getter unit includes a getter layer arranged on the upper surface of the integrated circuit substrate, a support layer, cavities formed between the integrated circuit substrate and the support layer that correspond the pixel unit and the getter unit, respectively, and a sealing layer arranged on an upper surface of the support layer, and the cavity inside the getter unit is in communication with the cavity inside the pixel unit;
or the pixel device includes a getter layer and a reflection layer that are arranged on the upper surface of the integrated circuit substrate, and an infrared sensor unit that is arranged above the reflection layer and is in correspondence to the reflection layer.

In an embodiment, the pixel-level package structure of the uncooled infrared detector further includes:
an anti-reflection layer arranged on an upper surface of the sealing layer.

In an embodiment, the anti-reflection layer is made of zinc sulfide or germanium.

In an embodiment, the support layer has a thickness ranging from 750 nm to 1250 nm inclusive.

In an embodiment, the sealing layer is made of germanium or zinc sulfide.

In an embodiment, the reflection layer has a thickness ranging from 300 Å to 2000 Å inclusive.

In an embodiment, the getter layer has a thickness ranging from 3000 Å to 7500 Å inclusive.

A manufacturing method of a pixel-level package structure of an uncooled infrared detector is further provided in the present application, including:
preparing an integrated circuit substrate;
forming a pixel device on an upper surface of the integrated circuit substrate; where
the pixel device includes a pixel unit and a getter unit arranged at a side of the pixel unit, the getter unit includes a getter layer arranged on the upper surface of the integrated circuit substrate, a support layer, cavities formed between the integrated circuit substrate and the support layer that correspond the pixel unit and the getter unit, respectively, and a sealing layer arranged on an upper surface of the support layer, and the cavity inside the getter unit is in communication with the cavity inside the pixel unit; or, the pixel device includes a getter layer and a reflection layer that are arranged on the upper surface of the integrated circuit substrate, and an infrared sensor unit that is arranged above the reflection layer and in correspondence to the reflection layer.

In an embodiment, in the case that the pixel device includes a getter layer and a reflection layer that are arranged on the upper surface of the integrated circuit substrate, and an infrared sensor unit that is arranged above the reflection layer and is in correspondence to the reflection layer, and the step of forming a pixel device on the upper surface of the integrated circuit substrate includes:
depositing a reflection layer to be processed on the upper surface of the integrated circuit substrate and patterning the reflection layer to be processed to form the reflection layer;
depositing a getter layer to be processed on the upper surface of the integrated circuit substrate, and patterning the getter layer to be processed to form the getter layer;
forming a first sacrificial layer on a region of the upper surface of the integrated circuit substrate that is not covered by the getter layer and the reflection layer, and on upper surfaces of the getter layer and the reflection layer;
etching the first sacrificial layer to form a groove and forming an electrode connection column in the groove;
forming an infrared sensor unit on a region of an upper surface of the first sacrificial layer in correspondence to the reflection layer;
forming a second sacrificial layer on a region of the upper surface of the first sacrificial layer that is not covered by the infrared sensor unit and on an upper surface of the infrared sensor unit;
etching the first sacrificial layer and the second sacrificial layer to form a support groove, where is implemented into two steps, where, in a first step, etching by a depth of reaching an upper surface of a communication channel between two adjacent pixel units, and/or of an communication channel between two adjacent getter units, and/or of an communication channel between one pixel unit and one getter unit that are adjacent, where the communication channel between two adjacent pixel units, the communication channel between two adjacent pixel units and the communication channel between one pixel unit and one getter unit that are adjacent are configured to communicate two adjacent pixel units, two adjacent pixel units and two adjacent pixel unit and getter unit, respectively, and in a second step, etching a non-channel channel region by a depth of reaching the upper surface of the integrated circuit substrate, where the non-channel region is the regions between two adjacent pixel units, and/or between two adjacent pixel units, and/or between one pixel unit and one getter unit that are adjacent, which is non-occupied by the communication channels, and the non-channel region is configured as a support;
forming a support layer in the support groove and etching the support layer to form a release hole;
releasing the first sacrificial layer and the second sacrificial layer via the release hole; and
forming a sealing layer on an upper surface of the support layer, and the release hole is filled by the sealing layer.

In an embodiment, after the sealing layer is formed on the upper surface of the support layer, the manufacturing method further includes:
forming an anti-reflection layer on an upper surface of the sealing layer.

The pixel-level package structure of the uncooled infrared detector provided in the present application includes an integrated circuit substrate and a pixel device arranged on an upper surface of the integrated circuit substrate. The pixel device includes a pixel unit and a getter unit arranged at a side of the pixel unit. The getter unit includes a getter layer arranged on the upper surface of the integrated circuit substrate, a support layer, and a sealing layer arranged on an upper surface of the support layer. A cavity inside the getter unit is in communication with a cavity inside the pixel unit. Alternatively, the pixel device includes a getter layer and a reflection layer that are arranged on the upper surface of the integrated circuit substrate, and an infrared sensor unit that is arranged above the reflection layer and in correspondence to the reflection layer.

It can be seen that the pixel-level package structure in the present application includes the integrated circuit substrate and the pixel device arranged on the upper surface of the pixel-level package structure. Two structures of the pixel device are provided. The pixel device of one structure includes a pixel unit and a getter unit arranged at a side of the pixel unit, the getter unit includes a getter layer, a support layer and a sealing layer, and a cavity inside the getter unit is in communication with a cavity inside the pixel unit. That is, the getter layer is not arranged in the pixel unit, and does not apply the absorption effect on the infrared radiation while obtain the gas gettering performance, i.e. cannot affect the pixel unit, and thus the performance of the pixel-level package structure is improved. The pixel device of the other structure includes a getter layer, a reflection layer, and an infrared sensor unit that is arranged above the reflection layer and in correspondence to the reflection layer. That is, the getter layer is not arranged in correspondence to the infrared sensor unit, and cannot affect the absorption of the infrared radiation by the infrared sensor unit, and thus the performance of the pixel-level package structure is improved. Moreover, since the infrared sensor unit is arranged in correspondence to the reflection layer rather than the getter layer, if the getter layer is affected by oxidation, and the reflectance is lowered, as well as if a significantly rough structure on the surface lowers the reflectance, the infrared sensor unit cannot be affected, and thus the precision of the pixel-level package structure is improved.

Moreover, a manufacturing method of a pixel-level package structure of an uncooled infrared detector that has the above advantages is further provided in the present application.

### BRIEF DESCRIPTION OF THE DRAWINGS

For more clearly illustrating embodiments of the present application or the technical solutions in the conventional technology, accompany drawings for description of the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic view of a pixel-level package structure of an uncooled infrared detector according to an embodiment of the present application;
FIG. 2 is a top view of the pixel-level package structure of the uncooled infrared detector shown in FIG. 1;
FIG. 3 is a structural schematic view of a pixel unit array of another pixel-level package structure of an uncooled infrared detector shown in FIG. 4;
FIG. 4 is a top view of another pixel-level package structure of an uncooled infrared detector according to an embodiment of the present application;
FIG. 5 is a structural schematic view of a getter unit in the pixel-level package structure of the uncooled infrared detector shown in FIG. 4;
FIG. 6 is a flowchart of a manufacturing method of a pixel-level package structure of an uncooled infrared detector according to an embodiment of the present application; and
FIG. 7 to FIG. 16 are process flowcharts of a section B-B of the pixel-level package structure of the uncooled infrared detector in FIG. 2.

### DETAILED DESCRIPTION OF THE EMBODIMENTS

In order for those skilled in the art to better understand solutions of the present application, the present application will be further described in detail in conjunction with drawings and embodiments hereinafter. It is obvious that the described embodiments are only a part of the embodiments according to the present application, rather than all of the embodiments. All the other embodiments obtained by those skilled in the art based on the embodiments in the present application without any creative work belong to the scope of protection of the present application.

In the following description, numerous specific details are set forth for thorough understanding of the present application. However, the present application may be implemented by other means different from those described herein. Similar extensions may be made by those skilled in the art without departing from the content of the present application. Therefore, the present application is not limited by the specific embodiments disclosed hereinafter.

As described in Background, in the existing pixel-level package structure, a getter layer is arranged in correspondence to an infrared sensor unit. The getter layer can apply an absorption effect on the infrared radiation, and affects absorption of the infrared radiation by the infrared sensor unit, thereby affecting the performance of the pixel-level package structure of the uncooled infrared detector. In addition, due to characteristics of the process for the pixel-level packaging, the getter layer arranged inside a pixel chamber has to resist the influence of oxidation during organic resist releasing process. A cracked rough structure presented on a surface of the getter layer can lower the reflectance of the getter layer. The better the gas gettering performance is, the more significant the cracked rough structure on the surface is. The organic resist releasing process lowers the reflectance of the getter. Taking a zirconium-based and titanium-based getter as an example, the releasing process lowers the reflectance of the getter by around 10%, which affects the detection precision of the infrared detector.

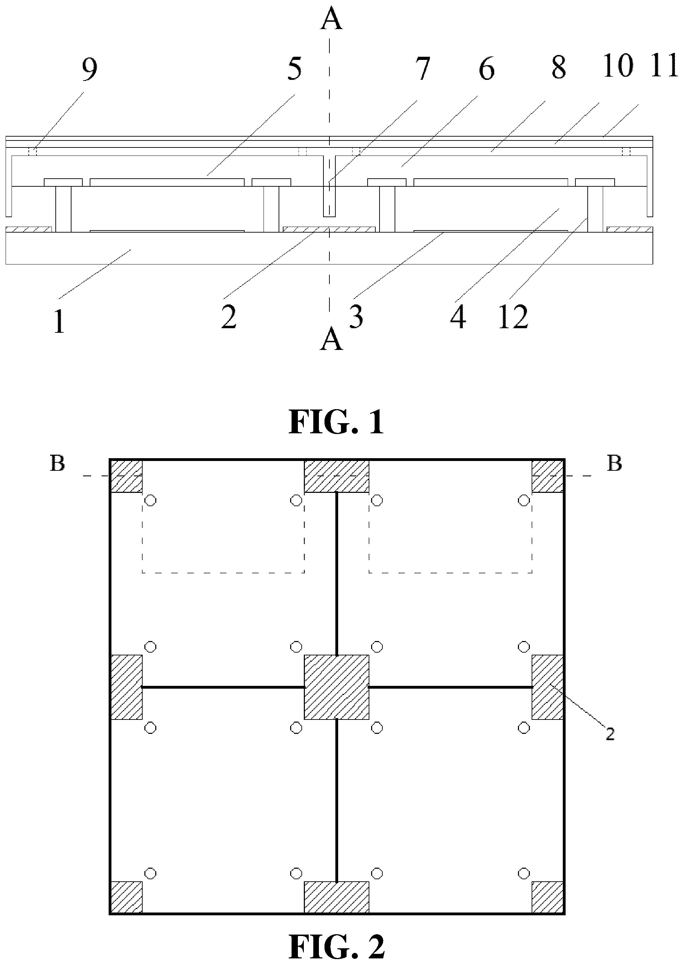

In view of this, a pixel-level package structure of an uncooled infrared detector is provided in the present application, referring to FIGS. 1 to 4, including:
an integrated circuit substrate 1 and a pixel device arranged on an upper surface of the integrated circuit substrate 1;
the pixel device includes: a pixel unit and a getter unit arranged at a side of the pixel unit, and the getter unit includes a getter layer 2 arranged on the upper surface of the integrated circuit substrate 1, a support layer 8, and a sealing layer 10 arranged on an upper surface of the support layer 8, cavities formed between the integrated circuit substrate 1 and the support layer 8 that correspond the pixel unit and the getter unit, respectively, where the cavity inside the getter unit is in communication with the cavity inside the pixel unit;
or, the pixel device includes: a getter layer 2 and a reflection layer 3 that are arranged on the upper surface of the integrated circuit substrate 1, and an infrared sensor unit 5 that is arranged above the reflection layer 3 and in correspondence to the reflection layer 3. The reflection layer 3 is located at central zone of the pixel device.

In an embodiment, the integrated circuit substrate is a COMS integrated circuit substrate 1.

Two structures of the pixel device are respectively described as follows.

In a pixel-level package structure of an uncooled infrared detector shown in FIG. 1 and FIG. 2, the pixel device includes: a getter layer 2 and a reflection layer 3 that are arranged on the upper surface of the integrated circuit substrate 1, and an infrared sensor unit 5 that is arranged above the reflection layer 3 and in correspondence to the reflection layer 3. The infrared sensor unit 5 includes a thermosensitive film that can convert a thermal signal to an electrical signal, which may be vanadium oxide, amorphous silicon or titanium oxide.

It should be noted that the pixel device further includes an electrode connection column 12 arranged on the upper surface of the integrated circuit substrate 1, a support layer 8, and a sealing layer 10 arranged on an upper surface of the support layer 8. For the specific arrangements of the electrode connection column 12, the support layer 8 and the sealing layer 10, reference is made to relative technologies.

The support layer 8 has a thickness ranging from 750 nm (inclusive) to 1250 nm (inclusive). The support layer 8 may be made of α-Si.

In the manufacturing process, the support layer 8 has to be perforated to form a release hole 9 in order to release sacrificial materials. It should be noted that the release hole 9 is filled by the sealing layer 10 to seal the package structure. One pixel device has one or more release holes 9. A width of the release hole 9 generally ranges from 200 nm to 500 nm.

The pixel devices are in communication with each other. The getter layer 2 is arranged at a gap between the pixel devices in the corner areas of the pixel devices. Two pixel devices are shown in FIG. 1.

The getter layer 2 is made of materials including but not limited to low-temperature activated materials with zirconium or titanium as a main composition and getters with good gas gettering performance. The getter layer 2 may be manufactured into a regular shape or an irregular shape, and the dimension of the getter layer 2 is determined according the pixel devices.

In order to ensure the gas gettering performance while saving getter materials and controlling the manufacturing cost, a thickness of the getter layer 2 may ranges from 3000 Å (inclusive) to 7500 Å (inclusive), such as 3500 Å, 4000 Å, 4500 Å, 5500 Å, 6500 Å, 7000 Å or the like.

The reflection layer 3 is made of metal, which may be selected on demand and is not limited in the present application. A thickness of the reflection layer 3 may ranges from 300 Å (inclusive) to 2000 Å (inclusive), such as 500 Å, 800 Å, 100 Å, 1300 Å, 1600 Å, 1800 Å or the like.

Further, in order to increase the transmittance of the infrared radiation and to improve the performance of the pixel-level package structure of the uncooled infrared detector, the pixel-level package structure of the uncooled infrared detector further includes:
an anti-reflection layer 11 arranged on an upper surface of the sealing layer 10.

It should be noted that, a material of the anti-reflection layer is not limited in the present application, and may be determined on demand. For example, the anti-reflection layer 11 may be made of germanium, or the anti-reflection layer 11 may be made of zinc sulfide.

It should also be noted that, a material of the sealing layer 10 is not specifically limited in the present application, and may be determined on demand. For example, the sealing layer 10 may be made of zinc sulfide, or the sealing layer 10 may be made of germanium.

A thickness of the sealing layer 10 generally ranges from 100 nm to 3000 nm, and a thickness of the anti-reflection layer 11 generally ranges from 100 nm to 3000 nm.

The pixel device in the present embodiment includes a getter layer 2, a reflection layer 3, and an infrared sensor unit 5 that is arranged above the reflection layer 3 and in correspondence to the reflection layer 3. That is, the getter layer 2 is not in correspondence to the infrared sensor unit 5, and thus cannot affect the absorption of the infrared radiation by the infrared sensor unit 5, which improves the performance of the pixel-level package structure. Furthermore, since the infrared sensor unit 5 is arranged in correspondence to the reflection layer 3 rather than the getter layer 2, in case that the getter layer 2 is affected by oxidation and the reflectance is lowered as well as a significantly rough structure on the surface lowers the reflectance, the infrared sensor unit 5 cannot be affected. Therefore, the precision of the pixel-level package structure is improved.

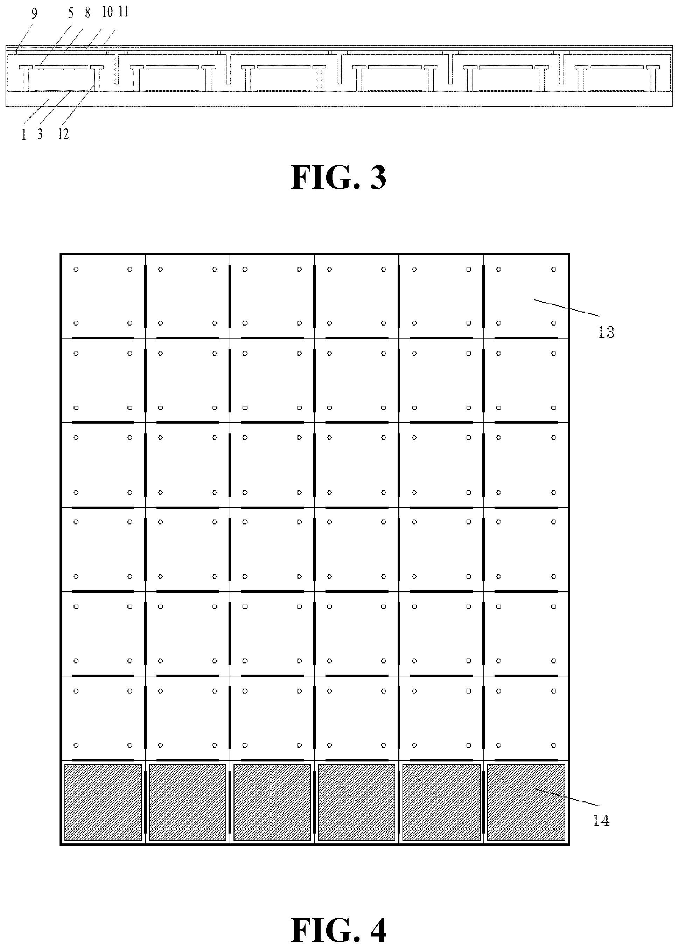

In the pixel-level package structure of the uncooled infrared detector shown in FIG. 4, the pixel device includes a pixel unit 13 and a getter unit 14. The getter unit 14 is arranged at a side of the pixel unit and includes a getter layer 2 arranged on the upper surface of the integrated circuit substrate 1, a support layer 8, cavities formed between the integrated circuit substrate 1 and the support layer 8 that correspond the pixel unit and the getter unit, respectively, and a sealing layer 10 arranged on an upper surface of the support layer 8. The cavity inside the getter unit is in communication with the cavity inside the pixel unit.

FIG. 3 is a structural schematic view of an array of the pixel unit 13 in the present embodiment. The pixel unit 13 includes a reflection layer 3 and an electrode connection column 12 that are arranged on the upper surface of the integrated circuit substrate 1, a support layer 8, an infrared sensor unit 5 that is arranged above the reflection layer 3 and in correspondence to the reflection layer 3, a sealing layer 10 arranged on an upper surface of the support layer 8, where a release hole 9 on the support layer 8 is filled by the sealing layer 10. The infrared sensor unit 5 includes a thermosensitive film which can convert a thermal signal to an electrical signal. Thermosensitive film may be vanadium oxide, amorphous silicon or titanium oxide. The pixel unit 13 does not include a getter layer 2.

The reflection layer 3 is made of metal, and the specific material may be selected on demand, which is not limited in the present application. The reflection layer 3 has a thickness ranging from 300 Å (inclusive) to 2000 Å (inclusive), such as 500 Å, 800 Å, 100 Å, 1300 Å, 1600 Å, 1800 Å or the like.

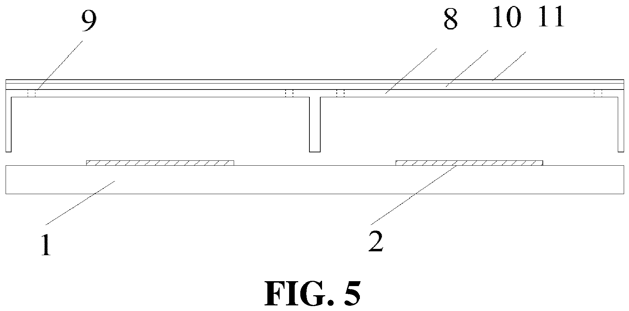

A structural schematic view of the getter unit 14 in the present embodiment is shown in FIG. 5. The getter unit includes a getter layer 2 arranged on the upper surface of the integrated circuit substrate 1, a support layer 8 and a sealing layer 10 arranged at an upper surface of the support layer 8. A cavity inside the getter unit is in communication with a cavity inside the pixel unit. In the manufacturing process, the support layer 8 has to be perforated to form a release hole 9 in order to release sacrificial materials. It should be noted that, the release hole 9 is filled by the sealing layer 10 to seal the package structure.

The getter layer 2 is arranged in the getter unit in which the infrared sensor unit 5 is not provided, and the getter unit and the pixel unit are in communication with each other.

In order to ensure the gas gettering performance while saving getter materials and controlling manufacturing cost, the getter layer 2 has a thickness ranging from 3000 Å (inclusive) to 7500 Å (inclusive), such as 3500 Å, 4000 Å, 4500 Å, 5500 Å, 6500 Å, 7000 Å or the like. The getter layer 2 is made of materials including but not limited to low-temperature activated materials with zirconium or titanium as a main composition, and materials with a good gas gettering performance.

A thickness of the support layer 8 may range from 750 nm (inclusive) to 1250 nm (inclusive). The support layer 8 may be made of α-Si. One pixel unit and one getter unit both include two release holes 9. The release hole 9 has a width generally ranging from 200 nm to 500 nm.

In order to increase the transmittance of the infrared radiation and to improve the performance of the pixel-level package structure of an uncooled infrared detector, the pixel-level package structure of the uncooled infrared detector further includes:
an anti-reflection layer 11 arranged on an upper surface of the sealing layer 10.

It should be noted that, a material of the anti-reflection layer 11 is not limited in the present application, and may be determined on demand. For example, the anti-reflection layer 11 may be made of germanium, or the anti-reflection layer 11 may be made of zinc sulfide or the like. If the sealing layer is made of germanium, the anti-reflection layer is made of zinc sulfide. If the sealing layer is made of zinc sulfide, the anti-reflection layer is made of germanium.

It should also be noted that a material of the sealing layer 10 is not limited in the present application, and may be selected on demand. For example, the sealing layer 10 may be made of zinc sulfide, or the sealing layer 10 may be made of germanium.

The pixel device in the present embodiment includes a pixel unit and a getter unit arranged at a side of the pixel unit. The getter unit includes a getter layer 2, a support layer 8 and a sealing layer 10, and a cavity inside the getter unit is in communication with a cavity inside the pixel unit. That is, the getter layer 2 is not arranged in the pixel unit, and does not apply absorption effect on the infrared radiation while obtain the gas gettering performance, i.e. the pixel unit is not affected, and thus the performance of the pixel-level package structure is improved.

It should be emphasized that, vacuum failure of one single pixel device can result in failure of the whole pixel-level package structure. In the present application, by adjustments made to coating materials and process, and coating parameters according to researches of Atomic Energy and Alternative Energies Commission based on a literature "Latest improvements in microbolometer thin film packaging", it ensures that there is no blind pixel due to vacuum failure.

A flowchart of a manufacturing method of a pixel-level package structure of an uncooled infrared detector is further provided in the present application, including the following steps.

Step S101, prepare an integrated circuit substrate.

The integrated circuit substrate is a CMOS integrated circuit substrate.

Step S102, provide a pixel device on an upper surface of the integrated circuit substrate;
where the pixel device includes a pixel unit and a getter unit arranged at a side of the pixel unit, the getter unit includes a getter layer arranged on the upper surface of the integrated circuit substrate, a support layer, and a sealing layer arranged on an upper surface of the support layer, cavities formed between the integrated circuit substrate and the support layer that correspond the pixel unit and the getter unit, respectively. The cavity inside the getter unit is in communication with the cavity inside the pixel unit; or, the pixel device includes a getter layer and a reflection layer that are arranged on the upper surface of the integrated circuit substrate, and an infrared sensor unit that is arranged above the reflection layer and in correspondence to the reflection layer.

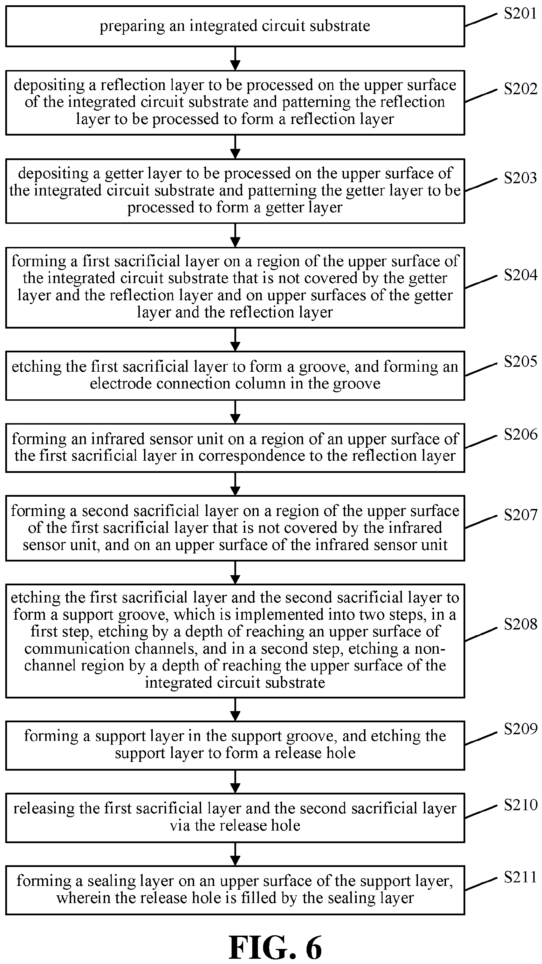

In a case that the pixel device includes a getter layer and a reflection layer that are arranged on the upper surface of the integrated circuit substrate, and an infrared sensor unit that is arranged above the reflection layer and in correspondence to the reflection layer, please refer to FIG. 6. FIG. 6 is a flowchart of a manufacturing method of a pixel-level package structure of an uncooled infrared detector according to an embodiment of the present application, which includes the following steps.

Step S201, prepare an integrated circuit substrate.

Step S202, deposit a reflection layer to be processed on the upper surface of the integrated circuit substrate and pattern the reflection layer to be processed to form a reflection layer.

Step S203, deposit a getter layer to be processed on the upper surface of the integrated circuit substrate, and pattern the getter layer to be processed to form a getter layer.

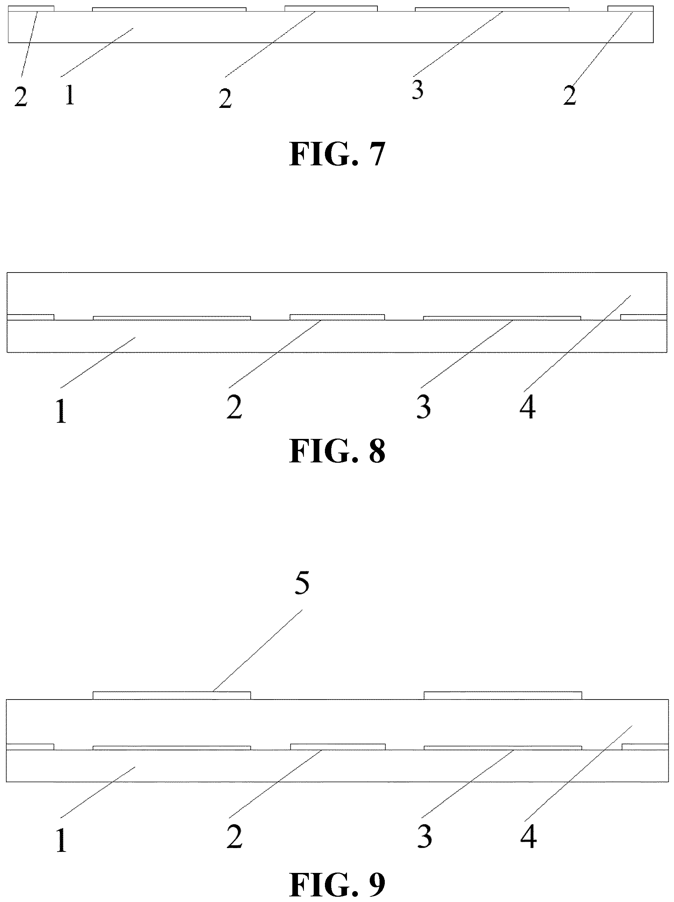

Reference to FIG. 7 is made for this step. The getter layer 2 and the reflection layer 3 are located on the upper surface of the integrated circuit substrate 1. The getter layer 2 has a thickness that may ranges from 3000 Å (inclusive) to 7500 Å (inclusive), and the reflection layer has a thickness that may ranges from 300 Å (inclusive) to 2000 Å inclusive (inclusive).

Step S204, form a first sacrificial layer on a region of the upper surface of the integrated circuit substrate that is not covered by the getter layer and the reflection layer and on the upper surfaces of the getter layer and the reflection layer.

Reference to FIG. 8 is made for this step. The first sacrificial layer 4 covers the getter layer 2, the reflection layer 3, and a region of the upper surface of the integrated circuit substrate 1 that is not covered by the getter layer 2 or the reflection layer 3.

The first sacrificial layer 4 is an organic sacrificial layer. The first sacrificial layer 4 may be made of polyimide or amorphous carbon, and the first sacrificial layer 4 has a thickness ranging from 1.5 µm to 2.5 µm.

Step S205, etch the first sacrificial layer to form a groove and form an electrode connection column in the groove.

Step S206, form an infrared sensor unit on a region of an upper surface of the first sacrificial layer in correspondence to the reflection layer.

Reference to FIG. 9 is made for this step. The infrared sensor unit 5 is located on the upper surface of the first sacrificial layer 4, and the infrared sensor unit 5 includes a thermosensitive film which can convert a thermal signal to an electrical signal, and the thermosensitive film may be made of vanadium oxide, amorphous silicon, titanium oxide and so on.

Step S207, form a second sacrificial layer on a region of the upper surface of the first sacrificial layer that is not covered by the infrared sensor unit and on an upper surface of the infrared sensor unit.

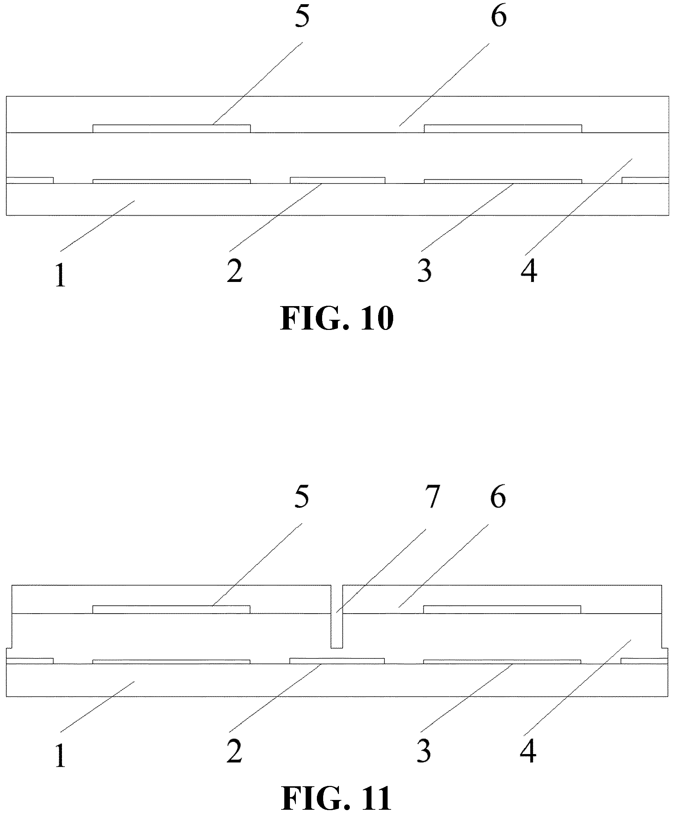

Referring to FIG. 10, the second sacrificial layer 6 covers the infrared sensor unit 5 and the first sacrificial layer 4. The second sacrificial layer 6 may be made of SiO2, SiN or the like, and the second sacrificial layer 6 has a thickness ranging from 1.0 µm to 2 µm.

Step S208, etch the first sacrificial layer and the second sacrificial layer to form a support groove, where this etching step is implemented into two steps: in a first step, etching by a depth of reaching an upper surface of a communication channel between two adjacent pixel units, an communication channel between two adjacent getter units, or an communication channel between one pixel unit and one getter unit that are adjacent, where the communication channel between two adjacent pixel units, the communication channel between two adjacent pixel units and the communication channel between one pixel unit and one getter unit that are adjacent are configured to communicate two adjacent pixel units, two adjacent pixel units and two adjacent pixel unit and getter unit, respectively. In a second step, etching a non-channel region by a depth of reaching the upper surface of the integrated circuit substrate, where the non-channel region is the region between two adjacent pixel units, between two adjacent pixel units or between one pixel unit and one getter unit that are adjacent, which is not occupied by the communication channels, and the non-channel region is configured as a support.

Referring to FIG. 11, a support groove 7 is formed after the etching, which is used for forming a support layer.

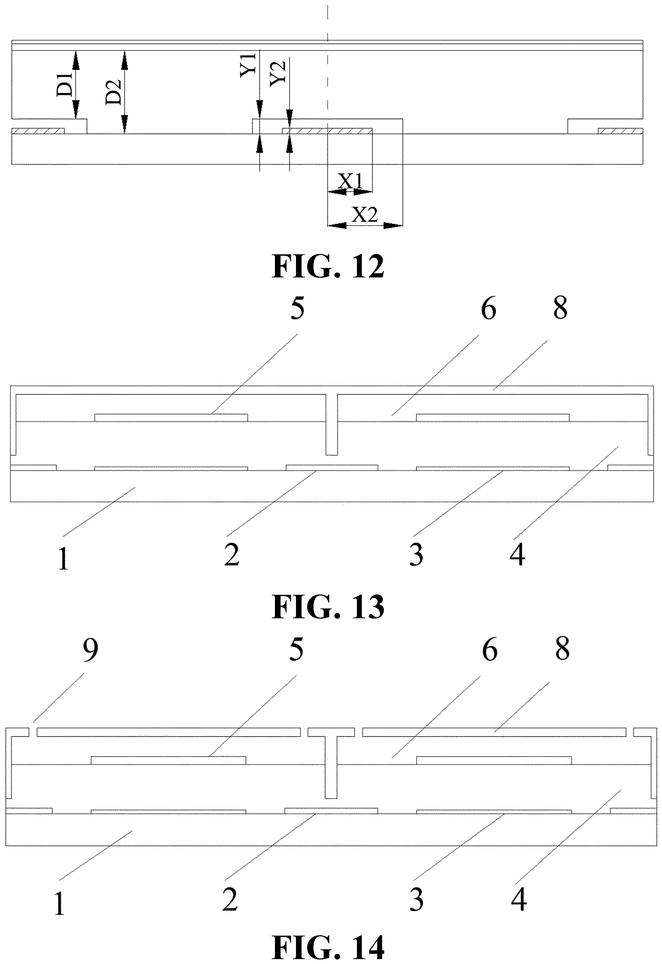

The etching is implemented into two steps. In a first step, etching by a depth of reaching an upper surface of these communication channels, and this etching depth of the first step is D1. In a second step, etching the non-channel region, by a depth of reaching the upper surface of the integrated circuit substrate, and this etching depth is D2. As shown in FIG. 12, which is a schematic view of a section taken along A-A in FIG. 1, it shows two pixel units at a left side and a right side of the dashed line, respectively. Half of a length of the getter layer is indicated by X1, half of a length of the communication channel is indicated by X2, a height of the communication channel is indicated by Y1, and the thickness of the getter layer is indicated by Y2. X2 is 1.5 to 3 times X1, and Y1 is 1.5 to 3 times Y2.

Step S209, form a support layer in the support groove, and the support layer is etched to form a release hole.

Reference to FIG. 13 is made for this step. The support layer 8 has a thickness that may ranges from 750 (inclusive) nm to 1250 nm (inclusive), and the support layer may be made of α-Si. Two release holes 9 are formed by etching each pixel device on the top of the support layer 8, as shown in FIG. 14, and each release hole has a width ranging from 200 nm to 500 nm.

It should be noted that, support layer materials are also deposited in the support groove 7, which belongs to the support layer.

Step S210, release the first sacrificial layer and the second sacrificial layer via the release holes.

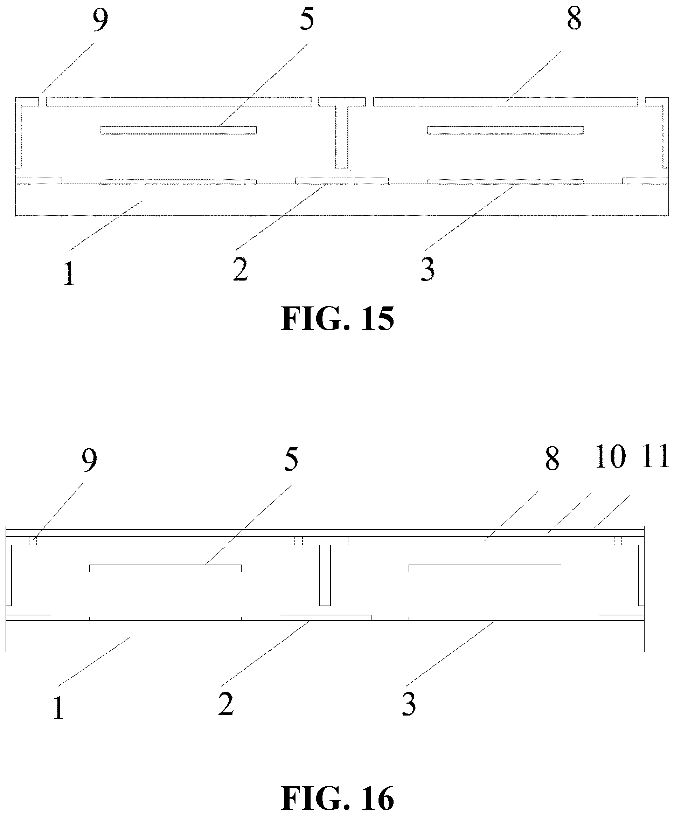

The first sacrificial layer and the second sacrificial layer are released via the release holes as shown in FIG. 15.

Step S211, form a sealing layer on an upper surface of the support layer, and the release holes are filled by the sealing layer.

Reference to FIG. 16 is made for this step. The sealing layer 10 has a thickness that generally ranges from 100 nm to 3000 nm, and the sealing layer 10 may be made of zinc sulfide or germanium.

It should be noted that FIG. 6 to FIG. 16 are process flowcharts of a section taken along B-B in FIG. 2, and the electrode connection column are not presented in the B-B section.

In the pixel-level package structure of the uncooled infrared detector manufactured in the present embodiment, the pixel device includes a getter layer, a reflection layer, and an infrared sensor unit that is arranged above the reflection layer and in correspondence to the reflection layer. That is, the getter layer is not arranged in correspondence to the infrared sensor unit, and cannot affect the absorption of the infrared radiation by the infrared sensor unit, and thus the performance of the pixel-level package structure is improved. Furthermore, since the infrared sensor unit is arranged in correspondence to the reflection layer rather than the getter layer, and thus, if the getter layer is affected by oxidation and the reflectance is lowered as well as if a significantly rough structure on the surface lowered the reflectance, the infrared sensor unit cannot be affected. Therefore the precision of the pixel-level package structure is improved.

Further, in an embodiment of the present application, after the sealing layer is formed on the upper surface of the support layer, the manufacturing method further includes:
form an anti-reflection layer on an upper surface of the sealing layer.

The anti-reflection layer is made of germanium or zinc sulfide, and the anti-reflection layer has a thickness that generally ranges from 100 nm to 3000 nm.

By providing the anti-reflection layer in the present embodiment, the transmittance of the infrared radiation can be increased, and the performance of the pixel-level package structure of an uncooled infrared detector can be improved.

In case that the pixel device includes a pixel unit and a getter unit arranged at a side of the pixel unit, that the getter unit includes a getter layer arranged on the upper surface of the integrated circuit substrate, a support layer, and a sealing layer arranged on an upper surface of the support layer, and that a cavity inside the getter unit is in communication with a cavity inside the pixel unit, a manufacturing method of a pixel-level package structure of an uncooled infrared detector is similar to the method according to the steps S201 to S210 as described above. The differences is in the existence and position of the reflection layer and the getter layer in the pixel unit and the getter unit, which can be specially adjusted according to the structural schematic views of FIG. 3 and FIG. 5, and the manufacturing process cannot be described in detail in the present application.

The above embodiments in this specification are described in a progressive manner. Each of the embodiments is mainly focused on describing its differences from other embodiments, and references may be made among these embodiments with respect to the same or similar portions among these embodiments. Since device embodiments are similar to method embodiments, the description thereof is relatively simple, and reference may be made to the description of the method embodiments for relevant parts.

A pixel-level package structure of an uncooled infrared detector, and a manufacturing method thereof are described in detail hereinabove. The principle and the embodiments of the present application are illustrated herein by specific examples. It should be noted that, for those skilled in the art, a few of modifications and improvements may be made to the present application without departing from the principle of the present application, and these modifications and improvements are also deemed to fall into the scope of the present application defined by the claims.

## Claims

1. A pixel-level package structure of an uncooled infrared detector, comprising:
an integrated circuit substrate; and
a pixel device arranged on an upper surface of the integrated circuit substrate, wherein
the pixel device comprises:
a pixel unit; and
a getter unit arranged at a side of the pixel unit, wherein the getter unit comprises a getter layer arranged on the upper surface of the integrated circuit substrate, a support layer, cavities formed between the integrated circuit substrate and the support layer that correspond the pixel unit and the getter unit, respectively, and a sealing layer arranged on an upper surface of the support layer, wherein the cavity inside the getter unit is in communication with the cavity inside the pixel unit;
or, the pixel device comprises:
a getter layer and a reflection layer that are arranged on the upper surface of the integrated circuit substrate; and
an infrared sensor unit that is arranged above the reflection layer and in correspondence to the reflection layer.

2. The pixel-level package structure of the uncooled infrared detector according to claim 1, further comprising:
an anti-reflection layer arranged on an upper surface of the sealing layer.

3. The pixel-level package structure of the uncooled infrared detector according to claim 2, wherein the anti-reflection layer is made of zinc sulfide or germanium.

4. The pixel-level package structure of an uncooled infrared detector according to claim 1, wherein the support layer has a thickness ranging from 750 nm to 1250 nm inclusive.

5. The pixel-level package structure of the uncooled infrared detector according to claim 1, wherein the sealing layer is made of germanium or zinc sulfide.

6. The pixel-level package structure of the uncooled infrared detector according to claim 1, wherein the reflection layer has a thickness ranging from 300 Å to 2000 Å inclusive.

7. The pixel-level package structure of the uncooled infrared detector according to any one of claims 1 to 6, wherein the getter layer has a thickness ranging from 3000 Å to 7500 Å inclusive.

8. A manufacturing method of a pixel-level package structure of an uncooled infrared detector, comprising:
preparing an integrated circuit substrate; and
forming a pixel device on an upper surface of the integrated circuit substrate, wherein
the pixel device comprises a pixel unit and a getter unit arranged at a side of the pixel unit, the getter unit comprises a getter layer arranged on the upper surface of the integrated circuit substrate, a support layer, cavities formed between the integrated circuit substrate and the support layer that correspond the pixel unit and the getter unit, respectively, and a sealing layer arranged on an upper surface of the support layer, wherein the cavity inside the getter unit is in communication with the cavity inside the pixel unit,
or, the pixel device comprises: a getter layer and a reflection layer that are arranged on the upper surface of the integrated circuit substrate, and an infrared sensor unit that is arranged above the reflection layer and in correspondence to the reflection layer.

9. The manufacturing method of the pixel-level package structure of the uncooled infrared detector according to claim 8, wherein the pixel device comprises a getter layer and a reflection layer that are arranged on the upper surface of the integrated circuit substrate, and an infrared sensor unit that is arranged above the reflection layer and in correspondence to the reflection layer, and the step of forming a pixel device on the upper surface of the integrated circuit substrate comprises:
depositing a reflection layer to be processed on the upper surface of the integrated circuit substrate and patterning the reflection layer to be processed to form the reflection layer;
depositing a getter layer to be processed on the upper surface of the integrated circuit substrate, and patterning the getter layer to be processed to form the getter layer;
forming a first sacrificial layer on a region of the upper surface of the integrated circuit substrate that is not covered by the getter layer and the reflection layer and on upper surfaces of the getter layer and the reflection layer;
etching the first sacrificial layer to form a groove and forming an electrode connection rod in the groove;
forming an infrared sensor unit on a region of an upper surface of the first sacrificial layer in correspondence to the reflection layer;
forming a second sacrificial layer on a region of the upper surface of the first sacrificial layer that is not covered by the infrared sensor unit and on an upper surface of the infrared sensor unit;
etching the first sacrificial layer and the second sacrificial layer to form a support groove, which is implemented into two steps, wherein,
in a first step, etching by a depth of reaching an upper surface of a communication channel between two adjacent pixel units, and/or of an communication channel between two adjacent getter units, and/or of an communication channel between one pixel unit and one getter unit that are adjacent, where the communication channel between two adjacent pixel units, the communication channel between two adjacent pixel units and the communication channel between one pixel unit and one getter unit that are adjacent are configured to communicate two adjacent pixel units, two adjacent pixel units and two adjacent pixel unit and getter unit, respectively, and
in a second step, etching a non-channel region by a depth of reaching the upper surface of the integrated circuit substrate, wherein the non-channel region is the regions between two adjacent pixel units, and/or between two adjacent pixel units, and/or between one pixel unit and one getter unit that are adjacent, which is non-occupied by the communication channels, and the non-channel region is configured as a support;
forming a support layer in the support groove and etching the support layer to form a release hole;
releasing the first sacrificial layer and the second sacrificial layer via the release hole; and
forming a sealing layer on an upper surface of the support layer, wherein the release hole is filled by the sealing layer.

10. The manufacturing method of the pixel-level package structure of the uncooled infrared detector according to claim 9, wherein, after the sealing layer is formed on the upper surface of the support layer, the manufacturing method further comprises:
forming an anti-reflection layer on an upper surface of the sealing layer.
